# EUROPÄISCHE PATENTANMELDUNG

(11) **EP 0 973 201 A1**
(43) Veröffentlichungstag der Anmeldung: **19.01.2000**
(21) Anmeldenummer: 99112845.5
(22) Anmeldetag: 02.07.1999
(51) Int. Cl.: H01L 27/108, H01L 21/8242

(54) **Stapelkondensator und entsprechendes Herstellungsverfahren**

(30) Priorität: 16.07.1998 DE 19832095
(71) Anmelder: SIEMENS AKTIENGESELLSCHAFT, 80333 München (DE)
(72) Erfinder: Winters, Reiner, 81379 München (DE)

(57) **Zusammenfassung**

Die vorliegende Erfindung schafft einen Stapelkondensator, insbesondere zur Verwendung in einer Halbleiterspeichervorrichtung, mit einem Halbleitersubstrat (10) eines ersten Leitungstyps (p) und einer darin befindlichen Wanne (20) eines zweiten Leitungstyps (n⁺); einem Stapel alternierender erster leitfähiger Schichten (40a, 40b, 40c) des ersten Leitungstyps (p⁺) und zweiter leitfähiger Schichten (60a, 60b) des zweiten Leitungstyps (n⁺), welche unter Zwischensetzen einer jeweiligen Isolationsschicht (30; 50a, 50b, 50c, 50d) auf dem Halbleitersubstrat (10) angeordnet sind; wobei zumindest jeweils zwei benachbarte Isolationsschichten (30; 50a, 50b, 50c, 50d) auf einer ersten Seite des Stapels durch Isolationsbrücken (70) derart miteinander verbunden sind, daß eine durchgehende Isolation der zweiten leitfähigen Schichten (60a, 60b) zur ersten Seite hin vorgesehen ist; einem auf der ersten Seite des Stapels vorgesehenen ersten Spacer (80), welcher einen ersten Kondensatoranschluß bildet und welcher vorzugsweise mit dem Halbleitersubstrat (10) und den ersten leitfähigen Schichten (40a, 40b, 40c) verbunden ist; und einem auf der zweiten Seite des Stapels vorgesehenen zweiten Spacer (130), welcher einen zweiten Kondensatoranschluß bildet und welcher mit der Wanne (20) und den zweiten leitfähigen Schichten (60a, 60b) verbunden ist.

## Beschreibung

Die vorliegende Erfindung betrifft einen Stapelkondensator und ein entsprechendes Herstellungsverfahren.

Obwohl auf beliebige Stapelkondensatoren anwendbar, werden die vorliegende Erfindung sowie die ihr zugrundeliegende Problematik in bezug auf einen Stapelkondensator zur Verwendung in einer Halbleiterspeichervorrichtung, z.B. einem DRAM (dynamischer Schreib/Lesespeicher) erläutert.

Integrierte Schaltungen (ICs) oder Chips verwenden Kondensatoren zum Zwecke der Ladungsspeicherung. Ein Beispiel eines IC, welcher Kondensatoren zum Speichern von Ladungen verwendet, ist ein Speicher-IC, wie z.B. ein Chip für einen dynamischen Schreib-/Lesespeicher mit wahlfreiem Zugriff (DRAM). Der Ladungszustand ("0" oder "1") in dem Kondensator repräsentiert dabei ein Datenbit.

Ein DRAM-Chip enthält eine Matrix von Speicherzellen, welche in Form von Zeilen und Spalten verschaltet sind. Üblicherweise werden die Zeilenverbindungen als Wortleitungen und die Spaltenverbindungen als Bitleitungen bezeichnet. Das Auslesen von Daten von den Speicherzellen oder das Schreiben von Daten in die Speicherzellen wird durch die Aktivierung geeigneter Wortleitungen und Bitleitungen bewerkstelligt.

Üblicherweise enthält eine DRAM-Speicherzelle einen mit einem Kondensator verbundenen Auswahltransistor. Der Transistor enthält zwei Diffusionsbereiche, welche durch einen Kanal getrennt sind, oberhalb dessen ein Gate angeordnet ist. Abhängig von der Richtung des Stromflusses bezeichnet man den einen Diffusionsbereich als Drain und den anderen als Source. Die Bezeichnungen "Drain" und "Source" werden hier hinsichtlich der Diffusionsbereiche gegenseitig austauschbar verwendet. Die Gates sind mit einer Wortleitung verbunden, und einer der Diffusionsbereiche ist mit einer Bitleitung verbunden. Der andere Diffusionsbereich ist mit dem Kondensator verbunden. Das Anlegen einer geeigneten Spannung an das Gate schaltet den Auswahltransistor ein, ermöglicht einen Stromfluß zwischen den Diffusionsbereichen durch den Kanal, um so eine Verbindung zwischen dem Kondensator und der Bitleitung zu bilden. Das Ausschalten des Auswahltransistors trennt diese Verbindung, indem der Stromfluß durch den Kanal unterbrochen wird.

Die in dem Kondensator gespeicherte Ladung baut sich mit der Zeit aufgrund eines inhärenten Leckstroms ab. Bevor sich die Ladung auf einen unbestimmten Pegel (unterhalb eines Schwellwerts) abgebaut hat, muß der Speicherkondensator aufgefrischt werden.

Das fortlaufende Bestreben nach Verkleinerung der Speichervorrichtungen fördert den Entwurf von DRAMs mit größerer Dichte und kleinerer charakteristischer Größe, d.h. kleinerer Speicherzellenfläche. Zur Herstellung von Speicherzellen, welche eine geringeren Oberflächenbereich besetzen, werden Komponenten mit kleinerer Grundfläche benötigt.

Eine Reduzierung der Grundfläche eines Kondensators führt in der Regel zu einer kleineren Kapazität, was durch die Konstruktion des Kondensators ausgeglichen werden muß. Denn eine zu geringe Kapazität des Speicherkondensators kann die Funktionstüchtigkeit und Verwendbarkeit der Speichervorrichtung widrig beeinflussen. Insbesondere hängen die Amplitude des Ausgangssignals und die Auffrischfrequenz einer Speicherzelle von der Größe der Kapazität ab.

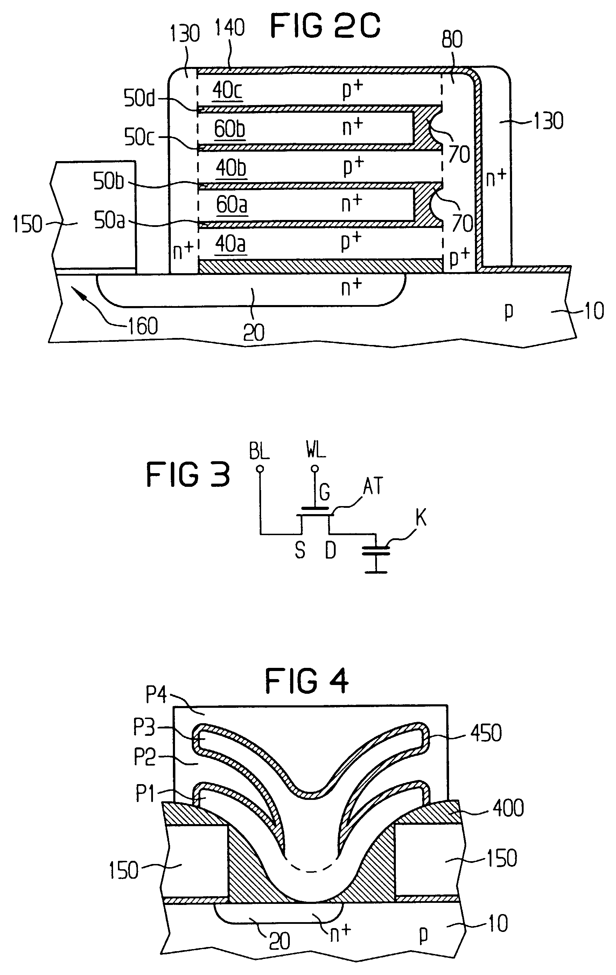

Fig. 3 ist eine schematische Darstellung des Ersatzschaltbilds für einen Stapelkondensator zur Verwendung in einer Halbleiterspeichervorrichtung. Darin bezeichnen BL eine Bitleitung, WL eine Wortleitung, AT einen Auswahltransistor und D,S,G Drain, Source, Gate des Auswahltransistors AT sowie K den Kondensator an sich.

Es gibt drei Arten von integrierten Kondensatoren: Planarkondensatoren, Grabenkondensatoren und Stapelkondensatoren. Planare Kondensatoren sind allgemeiner Standard; Graben- und Stapelkondensatoren werden insbesondere bei Megabit-DRAMs eingesetzt, weil Grabenkondensatoren und Stapelkondensatoren bei gleicher Grundfläche eine größere Kapazität als Planarkondensatoren besitzen.

Eine höhere Kapazität wird dadurch erreicht, daß der Grabenkondensator und Stapelkondensator eine dreidimensionale Struktur aufweisen, deren Oberfläche wesentlich größer ist als deren Grundfläche. Die Herstellung dieser dreidimensionalen Struktur erfordert in der Regel einen zusätzlichen Herstellungsaufwand.

Beim Grabenkondensator wird ausgenutzt, daß die Wandfläche eines tief in das Grundmaterial eingeätzten Grabens viel größer als seine Grundfläche ist.

Insbesondere unterscheidet man Grabenkondensatoren mit Polysiliziumplatte und Grabenkondensatoren mit vergrabener Platte.

Ein Stapelkondensator besteht prinzipiell aus mehreren übereinander angeordneten Planarkondensatoren, deren Elektroden parallel geschaltet sind. Als Stapelkondensatoren sind beispielsweise ein Kronen-Stapelkondensator und ein Rauh-Silizium-Stapelkondensator bekannt.

Nähere Einzelheiten zu Graben- und Stapelkondensatoren findet man beispielsweise in Widmann, Mader, Friedrich, Technologie hochintegrierter Schaltungen, zweite Auflage, Berlin, 1996, Seiten 273, 292f.

Bei diesen üblichen Graben- und Stapelkonzepten läßt sich eine Verkleinerung der Kondensatorgrundfläche allgemein nur durch eine höhere laterale Auflösung der Photolithographie erreichen. Die Tiefe der Gräben bzw. die Kantenlänge der Stapel wird durch die Grabenätztechnik begrenzt.

Fig. 4 ist eine schematische Darstellung eines bekannten Stapelkondensators zur Verwendung in einer Halbleiterspeichervorrichtung.

In Figur 4 bezeichnen P1-P4 Polysiliziumlagen, 10 ein Silizium-Halbleitersubstrat, 20 eine n⁺-Wanne, 150 Gatestrukturen, 400 eine Oxidschicht und 450 ONO-Schichten (ONO = Oxid/Nitrid/Oxid).

In Figur 4 ist die sogenannte Fin-Zelle gezeigt, welche insbesondere bei einem 16-MB-DRAM Anwendung findet. Es können beliebig viele Polysiliziumlagen P1-P4 aufeinander geschichtet werden. Zur Herstellung eines solchen Kondensators mit 2n Lagen sind 2n-1 Photoebenen und eine Prozessführung mit n-1 Opferschichten notwendig. Die Prozeßführung ist also aufwendig.

Die Aufgabe der vorliegenden Erfindung besteht darin, einen Stapelkondensator und ein entsprechendes Herstellungsverfahren anzugeben, wobei eine Integration großer Kapazitätswerte auf kleiner Siliziumgrundfläche auf einfache Art und Weise ohne hohen prozesstechnischen Aufwand möglich sind.

Erfindungsgemäß wird diese Aufgabe durch den in Anspruch 1 angegebenen Stapelkondensator bzw. das in Anspruch 7 angegebene Herstellungsverfahren gelöst.

Der erfindungsgemäße Stapelkondensator bzw. das Herstellungsverfahren weisen gegenüber den bekannten Lösungsansätzen folgende Vorteile auf: Es gibt nur zwei Lithographieschritte für eine beliebige Anzahl von Lagen, nämlich jeweils einen zur Gestaltung des linken und rechten Rands des Stapels. Alle Isolationen und Anschlüsse sind selbstjustierend. Es sind weder tiefe Gräben noch Unterätzungen notwendig. Es können unkritische Standard-Einzelprozesse Anwendung finden. Die minimale Kantenlänge des Kondensatorstapels beträgt ungefähr das Fünffache der Schichtdicke einer Polysiliziumschicht. Desweiteren ist keine Planarisierung notwendig.

Daraus ergibt sich, daß der Produktionsaufwand ist im Vergleich zu anderen üblichen Verfahren gering ist, und zwar vor allem dann, wenn das Verhältnis von Kapazität zur Grundfläche des Kondensators groß sein muß. Die Justierung der Photomasken ist unkritisch. Der Kondensator ist shrinkbar bzw. skalierbar.

Die vorliegende Erfindung schafft insgesamt eine neuartige Prozessabfolge und damit verbundene Topographie des erzeugten Stapelkondensators.

Die der vorliegenden Erfindung zugrundeliegende Idee besteht darin, daß zunächst die komplette Schichtenfolge des Stapelkondensators erzeugt und anschließend strukturiert wird. Bei der Strukturierung werden die elektrischen Anschlüsse der Schichten selbstjustierend erzeugt. Prozesstechnisch wird ausgenutzt, daß n-dotiertes Silizium mit KOH bzw. Cholin selektiv gegenüber p-dotiertem Silizium geätzt werden kann. Dadurch und durch eine alternierende Dotierung in der Schichtenfolge ist es möglich, die Polysiliziumschichten ohne zusätzliche Lithographieschritte abwechselnd mit dem linken und dem rechten Kondensatoranschluß zu verbinden. Für die Isolation im Bereich der Anschlüsse kommen an sich bekannte Spacerprozesse zum Einsatz. Die planare Gestalt des erfindungsgemäßen Kondensators sowie die Positionierung seiner elektrischen Anschlüsse sind vielseitig gestaltbar.

In den Unteransprüchen finden sich vorteilhafte Weiterbildungen und Verbesserungen des in Anspruch 1 angegebenen Stapelkondensators bzw. des in Anspruch 7 angegebenen Herstellungsverfahrens.

Gemäß einer bevorzugten Weiterbildung ist die Isolation der ersten leitfähigen Schichten zur zweiten Seite hin durch die mit dem zweiten Spacer gebildete Diodenstruktur realisiert. Hier ist beim Betrieb auf die Durchbruchsspannung der in Sperrichtung betriebenen Polysiliziumdiode zu achten.

Gemäß einer weiteren bevorzugten Weiterbildung sind jeweils zwei benachbarte Isolationsschichten alternierend auf der einen und der anderen Seite des Stapels durch Isolationsbrücken derart miteinander verbunden, daß eine durchgehende Isolation zwischen den ersten und zweiten leitfähigen Schichten vorgesehen ist. Diese Struktur ist unempfindlich gegenüber der Polarität der gewählten Kondensatorspannung.

Gemäß einer weiteren bevorzugten Weiterbildung weist das Halbleitersubstrat ein Si-Substrat auf und sind die Isolationsschichten und die Isolationsbrücken aus Siliziumdioxid oder Siliziumdioxid/ Siliziumnitrid/ Siliziumdioxid gebildet.

Gemäß einer weiteren bevorzugten Weiterbildung sind die ersten leitfähigen Schichten des ersten Leitungstyps p⁺-dotierte Polysiliziumschichten und die zweiten leitfähigen Schichten des zweiten Leitungstyps n⁺-dotierte Polysiliziumschichten. Diese Schichten sind mittels Standardtechniken leicht abscheidbar und selektiv strukturierbar.

Gemäß einer weiteren bevorzugten Weiterbildung ist die Wanne das Draingebiet eines zugehörigen Auswahltransistors. Dies schafft eine einfache Ankopplung zum Auswahltransistor.

Ausführungsbeispiele der Erfindung sind in den Zeichnungen dargestellt und in der nachfolgenden Beschreibung näher erläutert.

Es zeigen:
- Fig. 1A-O: die wesentlichen Verfahrensschritte einer ersten Ausführungsform des Verfahrens zur Herstellung des erfindungsgemäßen Stapelkondensators;
- Fig. 2A-C: die wesentlichen Verfahrensschritte einer zweiten Ausführungsform des Verfahrens zur Herstellung des erfindungsgemäßen Stapelkondensators im Anschluß an das Stadium von Fig. 1H der ersten Ausführungsform;
- Fig. 3: eine schematische Darstellung des Ersatzschaltbilds für einen Stapelkondensator zur Verwendung in einer Halbleiterspeichervorrichtung; und
- Fig. 4: eine schematische Darstellung eines bekannten Stapelkondensators zur Verwendung in einer Halbleiterspeichervorrichtung.

In den Figuren bezeichnen gleiche Bezugszeichen gleiche oder funktionsgleiche Elemente.

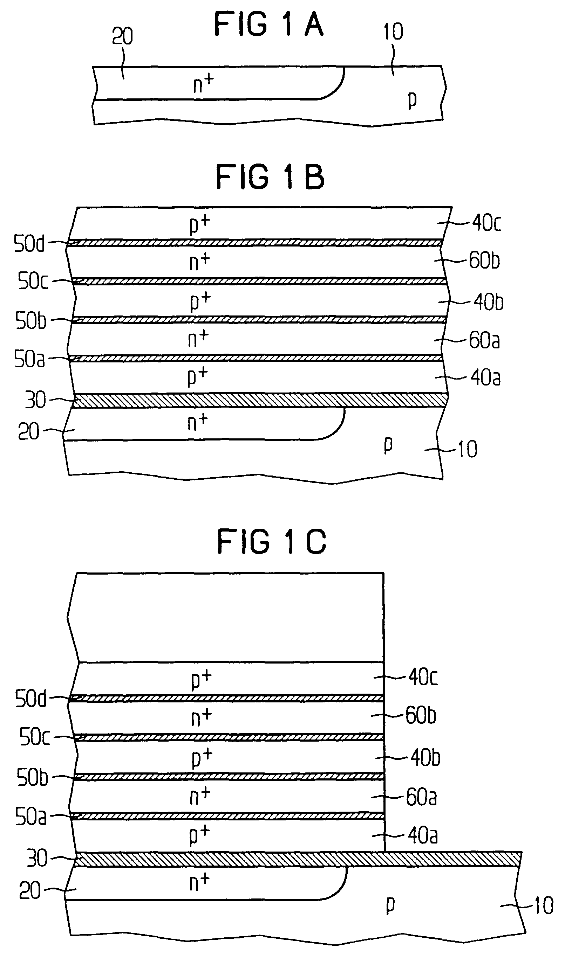

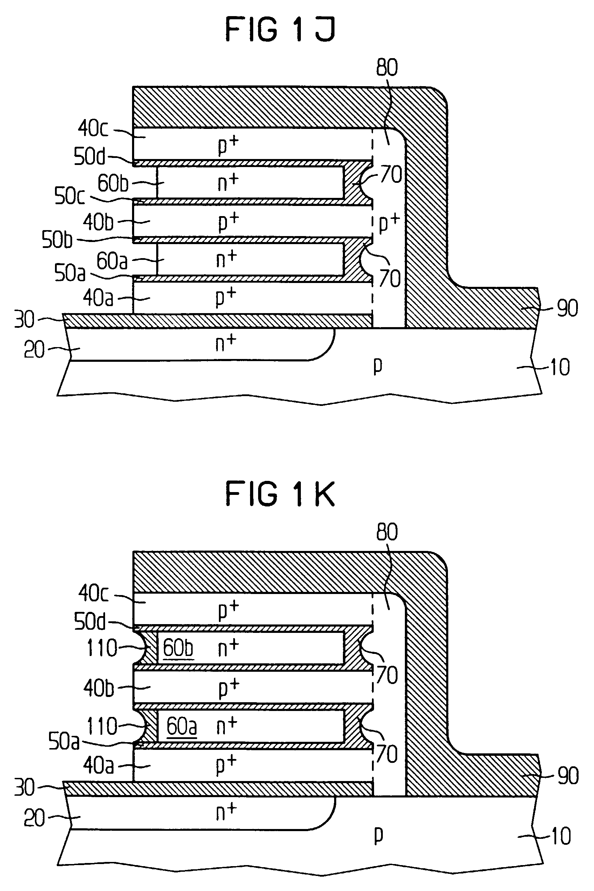

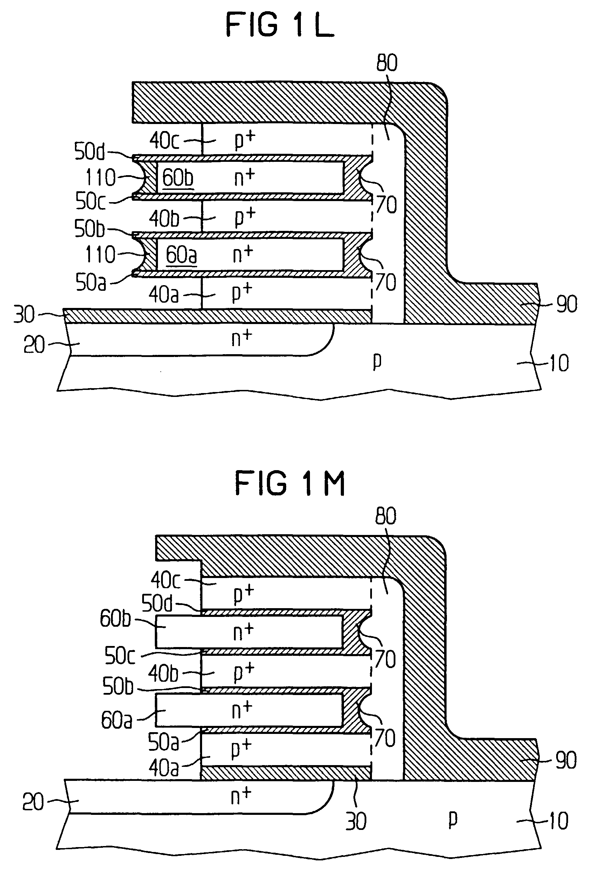

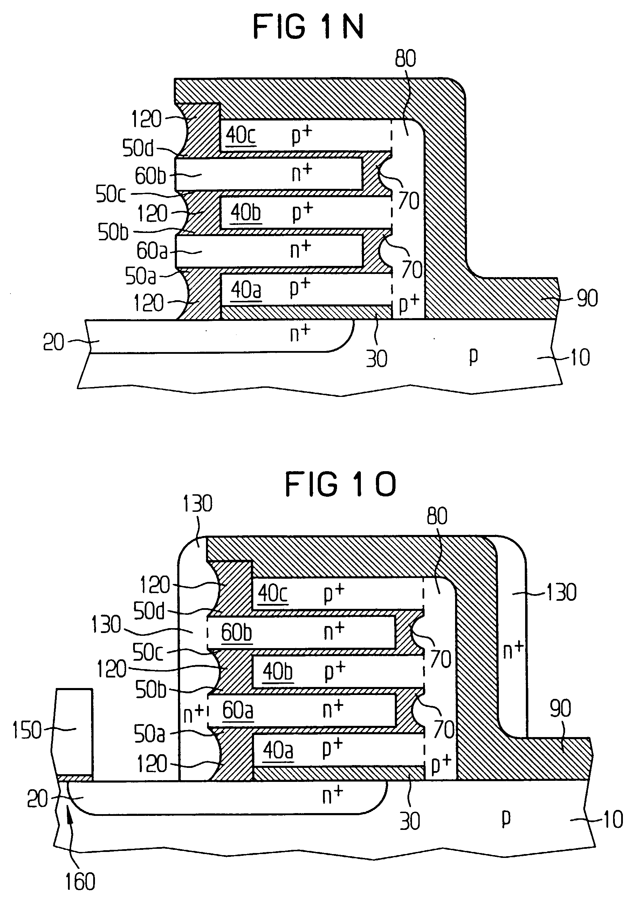

Fig. 1A-O zeigen die wesentlichen Verfahrensschritte einer ersten Ausführungsform des Verfahrens zur Herstellung des erfindungsgemäßen Stapelkondensators, insbesondere in Form sagittaler Schnitte durch den Kondensator, die so gewählt sind, daß sich die Kondensatoranschlüsse links und rechts vom Stapel befinden.

In Fig. 1A und 1B bezeichnen 10 ein p-Silizium-Halbleitersubstrat, 20 eine darin (z.B. durch Diffusion) eingebrachte n⁺-Wanne (Draingebiet eines Auswahltransistors), 30 eine ONO-Isolationsschicht, 50a-d Oxid-Isolationsschichten 40a, b, c erste leitfähige p⁺-Polysiliziumschichten und 60a, b zweite leitfähige n⁺-Polysiliziumschichten.

Die Bezeichnung Halbleitersubstrat 10 soll dabei allgemein verstanden werden und kann nicht nur ein massives Substrat, sondern auch eine entsprechende, darin vorgesehene Wanne bedeuten.

Wie in Figur 1A und 1B gezeigt, werden zunächst die ONO-Isolationsschicht 30 und darauf alternierend die p⁺-Polysiliziumschichten 40a bis 40c und n⁺-Polysilizium-schichten 60A, 60B mit den dazwischenliegenden Oxidschichten 50A, 50B, 50C, 50D mittels bekannter Technologie (z.B. CVD-Abscheidung) in Form eines Stapels abgeschieden.

Dann erfolgt gemäß Fig. 1C die Bildung einer ersten Photomaske 65 zur Definition der rechten Seite des Stapels aus den Polysiliziumschichten und den Oxidschichten. Nach Strukturierung der Photomaske 65 erfolgt ein Ätzen der in Fig. 1c rechten Seite des Stapels, wobei das Nitrid der ONO-Schicht 30 als Ätzstopp wirkt. Die rechte Seite des Stapels liegt dabei über dem p-Halbleitersubstrat 10.

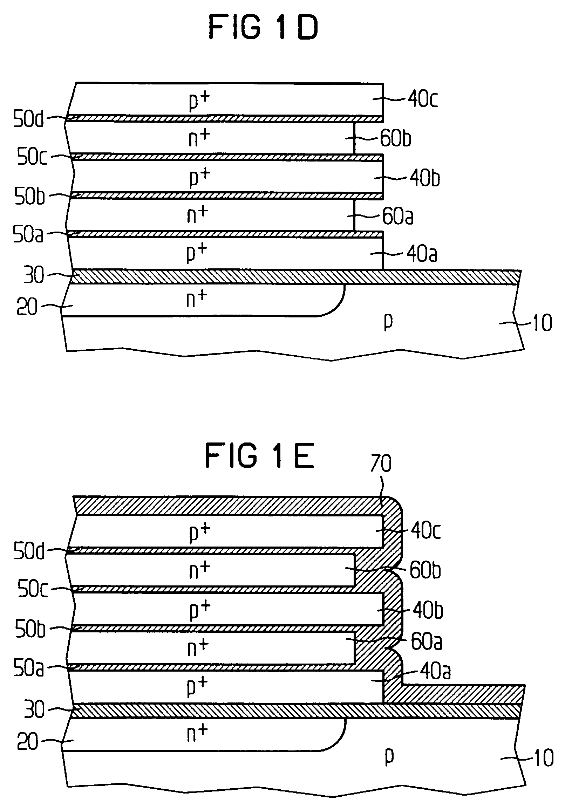

Wie in Figur 1D gezeigt, wird dann das n⁺-dotierte Polysilizium der Schichten 60a, 60b mit KOH oder Cholin selektiv geätzt, um eine jeweilige Unterätzung der n⁺-Polysiliziumschichten 60a, 60b gegenüber den benachbarten p⁺-Poly-siliziumschichten 40a, 40b, 40c zu bewirken.

Darauffolgend, wird, wie in Figur 1E gezeigt, eine Oxidschicht 70 konform, d.h. mit entsprechender Kantenabdeckung, abgeschieden. Die Schichtdicke der Oxidschicht beträgt mindestens die halbe Schichtdicke einer n⁺-Poly-siliziumschicht, so daß die Einätzung der n⁺-Schichten vollständig mit Oxid aufgefüllt wird.

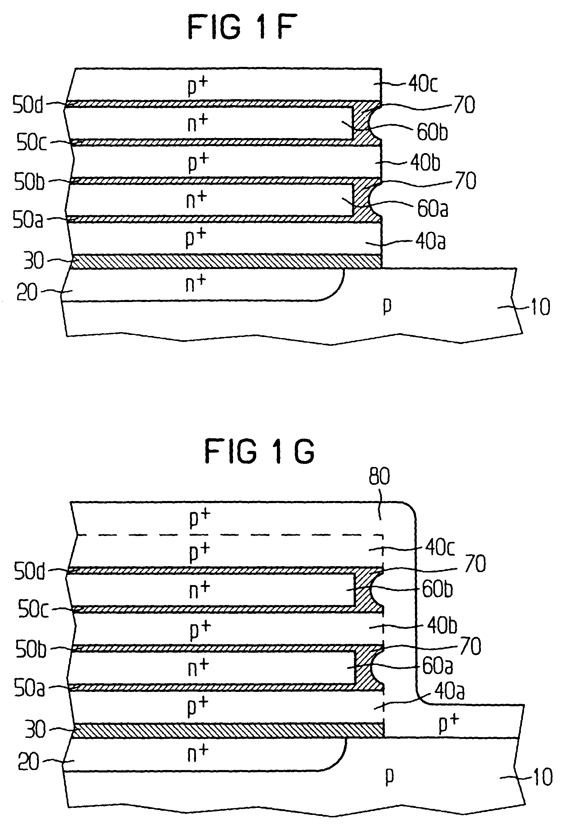

Die Oxidschicht 70 wird isotrop geätzt, um Isolationsbrücken 70 auf der rechten Seite des Stapels in Figur 1F zu bilden. Diese Isolationsbrücken bewirken, daß eine durchgehende Isolation der zweiten leitfähigen n⁺-Polysilizium-schichten 60a, 60b zur rechten Seite hin vorgesehen ist. Anschließend wird die ONO-Schicht 30 an der rechten Seite des Stapels entfernt, um die Oberfläche des Halbleitersubstrats 10 freizulegen.

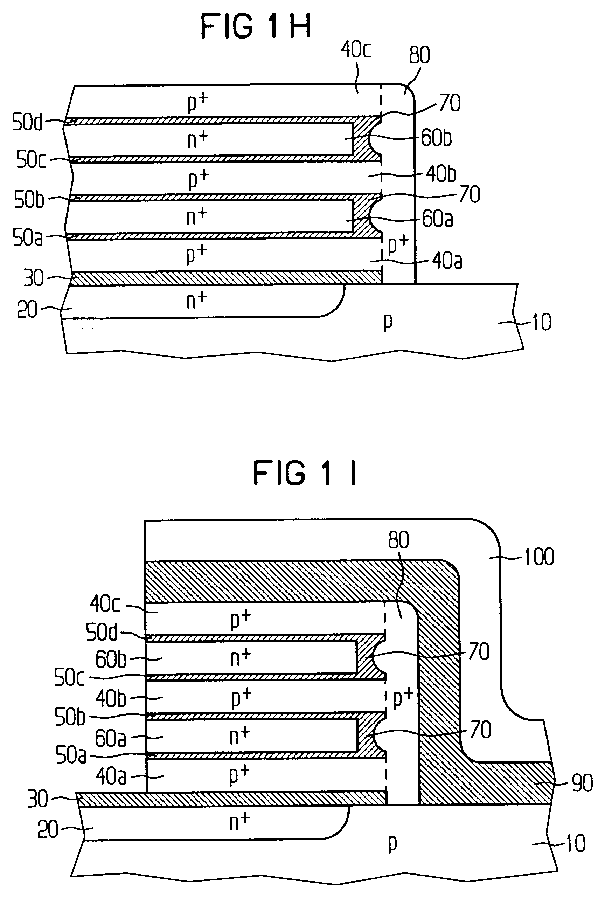

Danach wird, wie in Fig. 1G illustriert, eine p⁺-Poly-siliziumschicht 80 ganzflächig abgeschieden und anisotrop geätzt, um selbstjustiert einen rechten Seitenwandspacer 80 gemäß Figur 1H zu bilden, welcher die ersten leitfähigen p⁺-Polysiliziumschichten 40a, 40b, 40c mit der Oberfläche des Halbleitersubstrats 10 verbindet, um so einen ersten Kondensatoranschluß zu schaffen, der üblicherweise auf Massepotential liegt.

Wie in Figur 1I gezeigt, wird auf dem so erzeugten Stapel mit dem Seitenwandspacer 80 zunächst eine Nitridschicht 90 abgeschieden und darauffolgend eine zweite Photolackschicht 100, welche photolithographisch strukturiert wird. Es wird dann ein Ätzprozess, bei dem zuerst das Nitrid, und darauf nach Entfernen der zweiten Photolackschicht 100 das p⁺-Polysilizium, das Oxid und das n⁺-Polysilizium an der linken Seite des Stapels bis hinunter zur ONO-Schicht 30 geätzt werden, um so die linke Seite des Stapels zu definieren. Dabei dient wiederum die Nitridschicht der ONO-Schicht 30 als Ätzstopp.

Anschließend erfolgt, wie in Figur 1J gezeigt, eine erneute Ätzung mit KOH oder Cholin, um eine Unterätzung der n⁺-Polysiliziumschichten 60a, 60b gegenüber den benachbarten p⁺-Polysiliziumschichten 40a, 40b, 40c zu erzeugen.

Darauffolgend wird, wie in Figur 1K gezeigt, über der resultierenden Struktur eine Nitridschicht 110 konform abgeschieden und anisotrop geätzt, um Ätzstoppschichten bzw. -brücken 110 an der linken Seite der unterätzten n⁺-Polysiliziumschichten 60a, 60b zu bilden.

Danach wird, wie in Figur 1L gezeigt, das p⁺-Polysilizium der Schichten 40a, 40b, 40c geätzt, um eine Unterätzung der p^{+_} Polysiliziumschichten 40a, 40b, 40c gegenüber den benachbarten n⁺-Polysiliziumschichten 60a, 60b zu erzeugen. Die Nitridbrücken 110 verhindern dabei einen Ätzangriff auf die n⁺-Polysiliziumschichten 60a, 60b.

Anschließend erfolgt eine Nitrid-Ätzung, um das Nitrid der ONO-Schicht 30 und die Nitridbrücken 110 zu entfernen, wobei die Nitridschicht 90 nur gedünnt wird. Daraufhin erfolgt eine Oxidätzung, was zur in Fig. 1M gezeigten Struktur führt. Dabei wird die ONO-Schicht 30 an der linken Seite des Stapels entfernt, um die Oberfläche der n⁺-Wanne 20 freizulegen.

Mit Bezug auf Fig. 1N wird dann eine Oxidschicht 120 konform, d.h. mit entsprechender Kantenabdeckung, abgeschieden. Ähnlich wie die Oxidschicht 70 in Abb. 1E wird auch die Oxidschicht 120 isotrop geätzt, um Isolationsbrücken 120 auf der linken Seite des Stapels in Figur 1N zu bilden. Diese Isolationsbrücken bewirken, daß eine durchgehende Isolation der ersten leitfähigen p⁺-Poly-siliziumschichten 40a, 40b, 40c zur linken Seite hin vorgesehen ist.

Danach wird, wie in Fig. 1O illustriert, eine n⁺-Poly-siliziumschicht 130 ganzflächig abgeschieden und selbstjustierend und anisotrop geätzt, um einen linken Seitenwandspacer 130 gemäß Figur 1O zu bilden, welcher die zweiten leitfähigen n⁺-Polysiliziumschichten 60a, 60b mit der Oberfläche der n⁺-Wanne 20 verbindet, um so einen zweiten Kondensatoranschluß zu schaffen, der angesteuert über die Gatestruktur 150 mit einem Versorgungspotential verbindbar ist.

Damit ist diese erste Ausführungsform des Verfahrens zur Herstellung des erfindungsgemäßen Grabenkondensators im wesentlichen beendet.

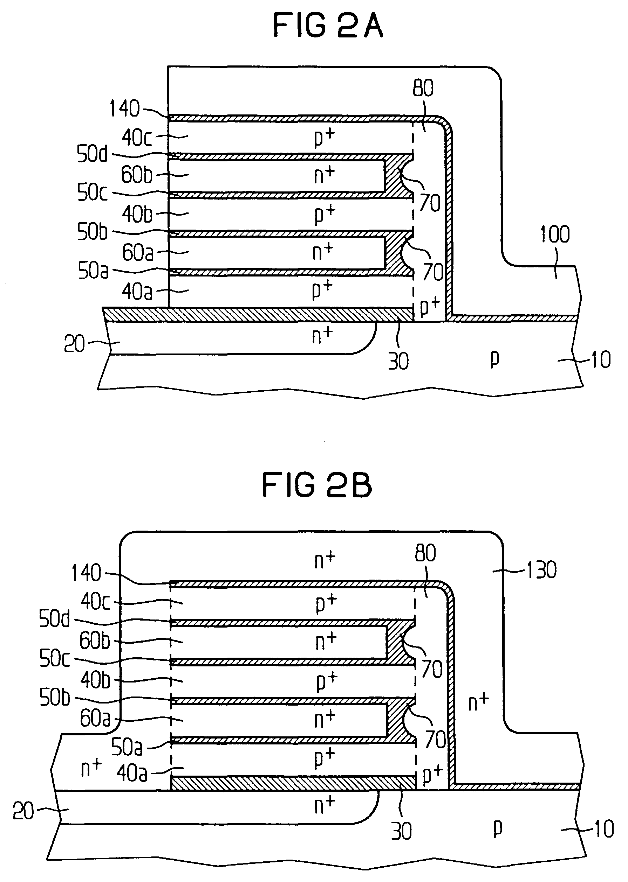

Fig. 2A-C zeigen die wesentlichen Verfahrensschritte einer zweiten Ausführungsform des Verfahrens zur Herstellung des erfindungsgemäßen Grabenkondensators im Anschluß an das Stadium von Fig. 1H der ersten Ausführungsform, insbesondere in Form sagittaler Schnitte durch den Kondensator, die so gewählt sind, daß sich die Kondensatoranschlüsse links und rechts vom Stapel befinden.

In Fig. 2A-C bezeichnet zusätzlich zu den bereits eingeführten Bezugszeichen 140 eine weitere Oxidschicht. Gemäß Figur 2A wird also bei der zweiten Ausführungsform nicht wie bei Figur 1I der ersten Ausführungsform eine Nitridschicht aufgetragen, sondern die weitere Oxidschicht 140.

Der Stapel ist also durch ein Oxid anstatt durch ein Nitrid abgedeckt. Mit einer zweiten Photolackmaske 100 wird die linke Seite des Stapels strukturiert, wobei das Nitrid der ONO-Schicht 30 als Ätzstopp wirkt.

Nach Entfernen der ONO-Schicht 30 wird eine n⁺-dotierte Polysiliziumschicht 130 abgeschieden (Fig. 2B). Durch anisotropes Rückätzen dieser Schicht entsteht auf der linken Seite des Stapels ein Spacer aus Polysilizium, der den Kondensator an das Draingebiet 20 anschließt.

Eine gewisse Komplikation schafft bei dieser zweiten Ausführungsform die Tatsache, daß die Isolation der ersten leitfähigen Schichten 40a, 40b, 40c zur linken Seite hin durch die mit dem zweiten Spacer 130 gebildete Diodenstruktur realisiert ist, also ein Teil der Isolation zwischen den Schichten aus einer in Sperrichtung betriebenen Polysiliziumdiode besteht. Dies bedingt gewisse Einschränkungen bei der Ansteuerung des Stapelkondensators im Betrieb.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Statt der Oxidisolation zwischen den Stapelschichten kann beispielsweise eine Oxid-Nitrit-Oxid-Isolation verwendet werden, was bessere Isolationseigenschaften und eine höhere Dielektrizitätskonstante mit sich bringt. Dann müssen die Ätzungen entsprechend gestaltet werden, um einen sicheren Ätzstopp zu gewährleisten.

Sämtliche Materialien sind nur beispielshaft erwähnt und können selbstverständlich durch entsprechende Materialien geeigneter Eigenschaften ersetzt werden.

Schließlich sind die Verwendungsmöglichkeiten des erfindungsgemäßen Stapelkondensators vielfältig und nicht auf Halbleiterspeicher begrenzt.

Die Verwendung des Begriffes Substrat soll in dieser Beschreibung nicht auf ein Wafersubstrat beschränkt sein, sondern kann Epitaxiesubtrate, Wannensubstrate, etc. umfassen.

Obwohl der auf der ersten Seite des Stapels vorgesehene erste Spacer, welcher den ersten Kondensatoranschluß bildet, vorzugsweise mit dem Halbleitersubstrat und den ersten leitfähigen Schichten verbunden ist und obwohl der auf der zweiten Seite des Stapels vorgesehene zweite Spacer, welcher den zweiten Kondensatoranschluß bildet, vorzugsweise mit der Wanne und den zweiten leitfähigen Schichten verbunden ist, ist die Erfindung nicht darauf beschränkt, und andere separate Anschlußgebiete anstelle des Halbleitersubstrats und der Wanne können zu diesem Zweck bereitgestellt werden.

## Patentansprüche

1. Verfahren zur Herstellung eines Stapelkondensators, insbesondere zur Verwendung in einer Halbleiterspeichervorrichtung mit folgenden Schritten:
Bereitstellen eines Halbleitersubstrats (10) eines ersten Leitungstyps (p) und einer darin befindlichen Wanne (20) eines zweiten Leitungstyps (n⁺);
Bilden eines Stapels alternierender erster leitfähiger Schichten (40a, 40b, 40c) des ersten Leitungstyps (p⁺) und zweiter leitfähiger Schichten (60a, 60b) des zweiten Leitungstyps (n⁺) unter Zwischensetzen einer jeweiligen Isolationsschicht (30; 50a, 50b, 50c, 50d) auf dem Halbleitersubstrat (10);
selektives Ätzen der zweiten leitfähigen Schichten (60a, 60b) an einem ersten Randbereich des Stapels, so daß diese gegenüber den ersten leitfähigen Schichten (40a, 40b, 40c) unterätzt sind;
Bilden von Isolationsbrücken (70) im Bereich der Unterätzungen derart, daß eine durchgehende Isolation der zweiten leitfähigen Schichten (60a, 60b) zum ersten Randbereich hin vorgesehen ist;
Bilden eines ersten Spacers (80) aus einem leitenden Material an dem ersten Randbereich des Stapels, welcher mit dem Halbleitersubstrat (10) und den ersten leitfähigen Schichten (40a, 40b, 40c) verbunden ist; und
Bilden eines zweiten Spacers (130) aus einem leitenden Material an einem zweiten Randbereich des Stapels, welcher mit der Wanne (20) und den zweiten leitfähigen Schichten (60a, 60b) verbunden ist.

2. Verfahren nach Anspruch 1, gekennzeichnet durch folgende Schritte vor dem Bilden des Spacers (130):
selektives Ätzen der zweiten leitfähigen Schichten (60a, 60b) an dem zweiten Randbereich des Stapels, so daß diese gegenüber den ersten leitfähigen Schichten (40a, 40b, 40c) unterätzt sind;
Bilden einer Ätzstoppschicht (110) im Bereich der Unterätzungen;
Ätzen der ersten leitfähigen Schichten (40a, 40b, 40c) an dem zweiten Randbereich des Stapels, so daß diese gegenüber den zweiten leitfähigen Schichten (60a, 60b) unterätzt sind;
Entfernen der Ätzstoppschicht (110);
Bilden von Isolationsbrücken (70) im Bereich der Unterätzungen derart, daß eine durchgehende Isolation der ersten leitfähigen Schichten (40a, 40b, 40c) zum zweiten Randbereich hin vorgesehen ist.

3. Verfahren nach Anspruch 1 oder 2, dadurch gekennzeichnet, daß die ersten leitfähigen Schichten (40a, 40b, 40c) des ersten Leitungstyps (p⁺) aus p⁺-dotierten Polysiliziumschichten und die zweiten leitfähigen Schichten (60a, 60b) des zweiten Leitungstyps (n⁺) aus n⁺-dotierten Polysiliziumschichten gebildet werden.

4. Verfahren nach Anspruch 3, dadurch gekennzeichnet, daß das selektive Ätzen mit KOH oder Cholin durchgeführt wird, wobei nur die n⁺-dotierten Polysiliziumschichten geätzt werden.

5. Verfahren nach einem der Ansprüche 1 bis 4, dadurch gekennzeichnet, daß nur zwei Photolithographieschritte durchgeführt werden, und zwar ein erster zur Bildung des ersten Randbereichs des Stapels und ein zweiter zur Bildung des zweiten Randbereichs des Stapels.

6. Verfahren nach einem der Ansprüche 1 bis 5, dadurch gekennzeichnet, daß der erste Spacer (80) durch Abscheidung von Polysilizium des ersten Leitungstyps (p⁺) und anschließendes selbstjustierendes anisotropes Ätzen gebildet wird.

7. Verfahren nach einem der Ansprüche 1 bis 6, dadurch gekennzeichnet, daß der zweite Spacer (130) durch Abscheidung von Polysilizium des zweiten Leitungstyps (n⁺) und anschließendes anisotropes Ätzen gebildet wird.

8. Verfahren nach einem der vorhergehenden Ansprüche, dadurch gekennzeichnet, daß als das Halbleitersubstrat (10) ein Si-Substrat verwendet wird und daß die Isolationsschichten (30; 50a, 50b, 50c, 50d) und die Isolationsbrücken (70) aus Siliziumdioxid oder Siliziumdioxid/ Siliziumnitrid/ Siliziumdioxid gebildet werden.

9. Verfahren nach einem der vorhergehenden Ansprüche, dadurch gekennzeichnet, daß als die ersten leitfähigen Schichten (40a, 40b, 40c) des ersten Leitungstyps (p⁺) p⁺-dotierte Polysiliziumschichten und als die zweiten leitfähigen Schichten (60a, 60b) des zweiten Leitungstyps (n⁺) n⁺-dotierte Polysiliziumschichten gebildet werden.
